(19) Europäisches Patentamt
European Patent Office
Office européen des brevets

(11) Veröffentlichungsnummer: **0 182 744 B1**

(12) **EUROPÄISCHE PATENTSCHRIFT**

(45) Veröffentlichungstag der Patentschrift: **12.08.92**

(51) Int. Cl.5: **C08L 63/02**, C08K 3/00, C08K 5/00, G03F 7/00

(21) Anmeldenummer: **85810524.0**

(22) Anmeldetag: **08.11.85**

(54) **Photohärtbare gefüllte Expoxidharz-Zusammensetzungen und deren Verwendung.**

(30) Priorität: **14.11.84 CH 5447/84**

(43) Veröffentlichungstag der Anmeldung:
**28.05.86 Patentblatt 86/22**

(45) Bekanntmachung des Hinweises auf die Patenterteilung:
**12.08.92 Patentblatt 92/33**

(84) Benannte Vertragsstaaten:
**BE CH DE FR GB IT LI NL SE**

(56) Entgegenhaltungen:
**EP-A- 0 094 915**
**US-A- 3 709 861**
**US-A- 3 989 644**

**Ullmanns Enc. der technischen Chemie, 18, 554-558, 4te Auflage**

**Epoxy Resin Chemistry, ACS Symposium Series 114, S. 12 und 13 (1979 publiziert v. Am. Chem. Soc.)**

(73) Patentinhaber: **CIBA-GEIGY AG**
**Klybeckstrasse 141**
**CH-4002 Basel(CH)**

(72) Erfinder: **Bühler, Niklaus, Dr.**
**Route du Pâquier 8**
**CH-1723 Marly(CH)**
Erfinder: **Giller, Gerald**
**Rue de la Lechere 15B**
**CH-1630 Bulle(CH)**

**EP 0 182 744 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die vorliegende Erfindung betrifft photohärtbare gefüllte Epoxidharz-Zusammensetzungen und deren Verwendung, besonders zum Erzeugen von Reliefstrukturen, Abbildungen oder Verklebungen.

Die europäischen Patentanmeldungen Nr. 094 915 A2 und 109 851 A2 beschreiben härtbare (polymerisierbare) Zusammensetzungen, die ein kationisch polymerisierbares organisches Material und organometallische Initiatoren, wie Metallocenkomplexe, enthalten. In den genannten Patentanmeldungen sind u.a. generisch Füllstoffe als weitere mögliche Zusätze erwähnt, spezifisch sind jedoch keine gefüllten Epoxidharz-Systeme offenbart.

Aus den U.S. Patentschriften 3.968.056 und 3.989.644 sind ferner strahlungshärtbare, besonders UV-härtbare, Zusammensetzungen zur Herstellung von leitenden Ueberzügen bekannt, die als Füllstoffe elektrisch leitende Metalle, wie silberbeschichtete Glaskügelchen, und als organisches Harz-Bindemittel unter anderem auch Epoxidharze enthalten können. Diese Stoffgemische können auch UV-Photosensiblisatoren, wie Ketone, Benzoin und Benzoinderivate oder aromatische Oniumsalze der Elemente der Gruppe VIa des periodischen Systems enthalten.

Die gemäss diesen Patentschriften verwendeten Füllstoffe weisen Mindestabmessungen von 6 µm, bevorzugt von 10 µm auf.

Die U.S. Patentschrift 3 709 861 beschreibt Gemische von Epoxidharzen und Säureanhydriden oder bestimmten Polymercaptanen als chemische Härter, die Cyclopentadienylmangantricarbonyl als Photoinitiator enthalten. Diese Gemische können neben vielen andersartigen Zusatzstoffen auch Russ oder metallhaltige Füllstoffe enthalten, über deren Teilchengrösse jedoch nichts offenbart ist. Der Füllstoffgehalt kann nach der Lehre dieses US Patents im allgemeinen bis zum 1,5-fachen des Epoxidharzgehaltes betragen, ist jedoch von der Teilchengrösse und -form ebenso abhängig wie von der Absorptionscharakteristik des Füllstoffs.

Gegenstand der Erfindung sind neue photohärtbare gefüllte Epoxidharzzusammensetzungen enthaltend

a) 5 - 40 Gew.-% eines von olefinisch ungesättigten C=C-Doppelbindungen freien Epoxidharzes oder Epoxidharzgemisches

b) 0,1 - 15 Gew.-% mindestens eines Photoinitiators der Formel I

$[(R^1)(R^2M)_a]^{+an}$ an/q $[LQ_m]^{-q}$ (I) ,

worin a 1 oder 2 und n und q unabhängig voneinander je eine ganze Zahl von 1 bis 3 sind,
M das Kation eines einwertigen bis dreiwertigen Metalls aus den Gruppen IVb bis VIIb, VIII oder Ib des periodischen Systems darstellt,
m eine der Wertigkeit von L entsprechende ganze Zahl ist und
Q ein Halogenatom,
L ein zweiwertiges bis siebenwertiges Metall oder Nichtmetall,
$R^1$ ein π-Aren und $R^2$ ein π-Aren oder das Anion eines π-Arens bedeuten, und

c) 30 - 90 Gew.-% mindestens eines feinteiligen Füllstoffes, ausgewählt aus der Gruppe bestehend aus Russ, Graphit, metallhaltigen Füllstoffen, Füllstoffen mit Halbleitereigenschaften, der in Form von im wesentlichen kugelförmigen, dendritischen oder lamellaren Teilchen vorliegt, wobei die mittlere Teilchengrösse bei den im wesentlichen kugelförmigen Teilchen zwischen 0,2 und 5 µm liegt und die dendritischen und lamellaren Teilchen eine Länge von 0,3 bis 20 µm und eine Schichtdicke von 0,1 bis 1 µm aufweisen, und

wobei sich die genannten Komponenten mit gegebenenfalls zusätzlich vorhandenem Flussmittel (d) und/oder üblichen Zusatzstoffen (e) zu 100 Gew.-% ergänzen.

Die erfindungsgemässen Zusammensetzungen können selbst bei hohen Anteilen an feinteiligem Füllstoff überraschenderweise sowohl mit sichtbarem als auch mit UV-Licht gehärtet werden. Sie ermöglichen ferner die Herstellung von Beschichtungen, die auch bei beträchtlichen Schichtdicken voll ausgehärtet werden können, obwohl elektrisch leitende Füllstoffe, wie Metallpulver, Russ oder Graphit, enthaltende Beschichtungsmassen im allgemeinen unter UV-Licht nur ungenügend aushärten, weil das Licht an der Oberfläche der Metallpulver stark reflektiert bzw. durch den Russ oder Graphit stark absorbiert wird.

Als Epoxidharze (a) kommen vor allem solche mit durchschnittlich mehr als einer an ein Heteroatom, z.B. an ein S- und vorzugsweise an ein O- oder N-Atom, gebundenen Gruppe der Formel II

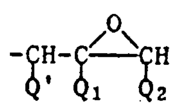 (II)

in Betracht, wobei Q' und $Q_2$ je ein Wasserstoffatom und $Q_1$ ein Wasserstoffatom oder eine Methylgruppe bedeuten oder Q' und $Q_2$ zusammen $-CH_2CH_2-$ oder $-CH_2CH_2CH_2-$ und $Q_1$ ein Wasserstoffatom bedeuten.

Als Beispiele solcher Harze seien Polyglycidyl- und Poly(β-methylglycidyl)ester genannt, die sich von aliphatischen, cycloaliphatischen oder aromatischen Polycarbonsäuren ableiten. Beispiele geeigneter Polycarbonsäuren sind Bernsteinsäure, Glutarsäure, Adipinsäure, Pimelinsäure, Korksäure,

Azelainsäure, Sebacinsäure, dimerisierte oder trimerisierte Linolsäure, Tetrahydrophthalsäure, 4-Methyltetrahydrophthalsäure, Hexahydrophthalsäure, 4-Methylhexahydrophthalsäure, Phthalsäure, Iso- und Terephthalsäure.

Weitere Beispiele sind Polyglycidyl- und Poly-($\beta$-methylglycidyl)äther, die durch Umsetzung einer mindestens zwei alkoholische und/oder phenolische Hydroxylgruppen pro Molekül enthaltenden Verbindung mit Epichlorhydrin oder mit Allylchlorid und anschliessende Epoxidierung mit Persäuren erhalten werden.

Geeignete Polyole sind z.B. Aethylenglykol, Diäthylenglykol, Poly(oxyäthylen)glykole, Propan-1,2-diol, Poly(oxypropylen)glykole, Propan-1,3-diol, Butan-1,4-diol, Poly(oxytetramethylen)-glykole, Pentan-1,5-diol, Hexan-2,4,6-triol, Glycerin, 1,1,1-Trimethylolpropan, Pentaerythrit und Sorbit; 1,3- und 1,4-Cyclohexandiol, Bis-(4-hydroxycyclohexyl)-methan, 2,2-Bis-(4-hydroxycyclohexyl)propan und 1,1-Bis-(hydroxymethyl)cyclohex-3-en; N,N-Bis(2-hydroxyäthyl)anilin und 4,4'-Bis(2-hydroxyäthylamino)diphenylmethan; Resorcin, Hydrochinon, Bis(4-hydroxyphenyl)methan (Bisphenol F), 2,2-Bis(4-hydroxyphenyl)propan (Bisphenol A), 2,2-Bis(4-hydroxy-3,5-dibromphenyl)propan (Tetrabrombisphenol A), 1,1,2,2-Tetrakis-(4-hydroxyphenyl)äthan, 4,4'-Dihydroxybiphenyl, Bis-(4-hydroxyphenyl)sulfon sowie Novolake aus Formaldehyd oder Acetaldehyd und Phenol, Chlorphenol oder Alkylpenolen mit bis zu 9 C-Atomen im Alkyl, besonders Kresol- und Phenol-Novolake.

Als Poly(N-glycidyl)-Verbindungen kommen durch Dehydrochlorierung von Umsetzungsprodukten aus Epichlorhydrin und Aminen mit mindestens zwei Aminwasserstoffatomen erhaltene Produkte in Betracht. Geeignete Amine sind z.B. Anilin, n-Butylamin, Bis(4-aminophenyl)methan, 1,3- und 1,4-Xylylendiamin, 1,3- und 1,4-Bis(aminomethyl)-cyclohexan und Bis(4-methylaminophenyl)methan. Triglycidylisocyanurat, N,N'-Diglycidylderivate von cyclischen Alkylenharnstoffen, wie Aethylenharnstoff und 1,3-Propylenharnstoff, oder Hydantoinen, wie 5,5-Dimethylhydantoin, sind weitere geeignete derartige Verbindungen.

Poly(S-glycidyl)-verbindungen sind z.B. die Di-S-Glycidylderivate von Dithiolen, wie Aethan-1,2-dithiol und Bis-(4-mercaptomethylphenyl)äther.

Beispiele für Epoxidharze mit einer oder mehreren Gruppen der Formel II, in welcher Q' und $Q_2$ zusammen eine Gruppe $-CH_2CH_2-$ oder $-CH_2CH_2CH_2-$ bedeuten, sind Bis(2,3-epoxycyclopentyl)äther, 2,3-Epoxycyclopentylglycidyläther, 1,2-Bis(2,3-epoxycyclopentyloxy)äthan,3,4-Epoxy-6-methylcyclohexylmethyl-3',4'-epoxy-6'-methylcyclohexan-carboxylat und 2-(3,4-Epoxy)-cyclohexyl-5,5-spiro(3',4'-epoxy)cyclohexan-dioxan.

Ebenfalls einsetzbar sind Epoxidharze, in welchen die Epoxidgruppen an Heteroatome verschiedener Art gebunden sind, oder in denen einige oder sämtliche Epoxidgruppen mittelständig sind, wie beispielsweise das N,N,O-Triglycidylderivat des 4-Aminophenols, N-Glycidyl-N'-(2-glycidyloxypropyl)-5,5-dimethylhydantoin, Vinylcyclohexendioxid, Limonendioxid und Dicyclopentadiendioxid.

Die Epoxidharze (a) können fest oder flüssig sein. Bevorzugt sind Epoxidharze mit einem Epoxidgehalt von 1,0 bis 5,5.

Bevorzugt setzt man als Komponente (a) gegebenenfalls vorverlängerte Diglycidyläther von zweiwertigen Phenolen oder zweiwertigen aliphatischen Alkoholen mit 2 bis 4 C-Atomen, vor allem gegebenenfalls vorverlängerte Diglycidyläther von 2,2-Bis-(4-hydroxyphenyl)propan, 2,2-Bis(3,5-dibrom-4-hydroxyphenyl)propan, Bis(4-hydroxyphenyl)methan, Bis(4-hydroxycyclohexyl)methan oder 2,2-Bis(4-hydroxycyclohexyl)propan,Polyglycidyläther von Novolaken, oder tetraglycidyliertes 4,4'-Diaminodiphenylmethan ein. Ganz besonders bevorzugt sind gegebenenfalls vorverlängerte Diglycidyläther von Bisphenol A, Tetrabrom-Bisphenol A oder Bisphenol F, und insbesondere Polyglycidyläther von Phenol-Formaldehyd- oder Kresol-Formaldehyd-Novolaken, oder Gemische davon.

Als $\pi$-Arene $R^1$ und $R^2$ kommen insbesondere aromatische Gruppen mit 6 bis 24 Kohlenstoffatomen oder heteroaromatische Gruppen mit 3 bis 30 Kohlenstoffatomen in Betracht, wobei diese Gruppen gegebenenfalls durch gleiche oder verschiedene einwertige Reste wie Halogenatome, vorzugsweise Chlor- oder Bromatome, oder $C_1$-$C_8$-Alkyl-, $C_1$-$C_8$-Alkoxy-, Cyan-, $C_1$-$C_8$-Alkylthio-, $C_2$-$C_6$-Monocarbonsäurealkylester-, Phenyl-, $C_2$-$C_5$-Alkanoyl- oder Benzoylgruppen einfach oder mehrfach substituiert sein können. Diese $\pi$-Arengruppen können einkernige, kondensierte mehrkernige oder unkondensierte mehrkernige Systeme darstellen, wobei in den zuletzt genannten Systemen die Kerne direkt oder über Brückenglieder, wie -S- oder -O-, verknüpft sein können.

$R^2$ als das Anion eines $\pi$-Arens kann ein Anion eines $\pi$-Arens der oben genannten Art sein, zum Beispiel das Indenylanion und insbesondere das Cyclopentadienylanion, wobei auch diese Anionen gegebenenfalls durch gleiche oder verschiedene einwertige Reste, wie $C_1$-$C_8$-Alkyl-, $C_2$-$C_6$-Monocarbonsäurealkylester-, Cyan-, $C_2$-$C_5$-Alkanoyl- oder Benzoylgruppen einfach oder mehrfach substituiert sein können.

Die Alkyl-, Alkoxy-, Alkylthio-, Monocarbonsäurealkylester- und Alkanoylsubstituenten können dabei geradkettig oder verzweigt sein. Als typische Alkyl-, Alkoxy-, Alkylthio-, Monocarbonsäurealkylester- bzw. Alkanoylsubstituenten seien Methyl, Aethyl, n-Propyl, Isopropyl, n-Butyl, sek.-Butyl, tert.-Butyl, n-Pentyl, n-Hexyl und n-Octyl, Methoxy, Aethoxy, n-Propoxy, Isopropoxy, n-Butoxy, n-Hexyloxy und n-Octyloxy, Methylthio, Aethylthio, n-Propylthio, Isopropylthio, n-Butylthio, n-Pentylthio und Hexylthio, Carbonsäuremethyl-, -äthyl-, -n-propyl-, -isopropyl-, -n-butyl- und -n-pentylester bzw. Acetyl, Propionyl, Butyryl und Valeroyl genannt. Dabei sind Alkyl-, Alkoxy-, Alkylthio- und Monocarbonsäurealkylestergruppen mit 1 bis 4 und insbesondere 1 oder 2 Kohlenstoffatomen in den Alkylteilen sowie Alkanoylgruppen mit 2 oder 3 Kohlenstoffatomen bevorzugt. Als substituierte $\pi$-Arene oder Anionen von substituierten $\pi$-Arenen werden solche bevorzugt, die einen oder zwei der obengenannten Substituenten, insbesondere Chlor- oder Bromatome, Methyl-, Aethyl-, Methoxy-, Aethoxy-, Cyan-, Carbonsäuremethyl- oder -äthylgruppen und Acetylgruppen, enthalten.

Als $R^1$ und $R^2$ können gleiche oder verschiedene $\pi$-Arene vorliegen. Als heteroaromatische $\pi$-Arene eignen sich S-, N- und/oder O-Atome enthaltende Systeme. Heteroaromatische $\pi$-Arene, die S- und/oder O-Atome enthalten, sind bevorzugt. Beispiele für geeignete $\pi$-Arene sind Benzol, Toluol, Xylole, Aethylbenzol, Cumol (Isopropylbenzol), Methoxybenzol, Aethoxybenzol, Dimethoxybenzol, p-Chlortoluol, Chlorbenzol, Brombenzol, Dichlorbenzol, Acetylbenzol, Trimethylbenzol, Trimethoxybenzol, Naphthalin, 1,2-Dihydronaphthalin, 1,2,3,4-Tetrahydronaphthalin, Methylnaphthaline, Methoxynaphthaline, Aethoxynaphthaline, Chlornaphthaline, Bromnaphthaline, Biphenyl, Inden, Fluoren, Phenanthren, Anthracen, 9,10-Dihydroanthracen, Triphenylen, Pyren, Naphthacen, Coronen, Thiophen, Chromen, Xanthen, Thioxanthen, Benzothiophen, Naphthothiophen, Thianthren, Diphenylenoxid, Diphenylensulfid, Acridin und Carbazol.

Wenn $a = 2$ ist, stellt $R^2$ vorzugsweise je das Anion eines $\pi$-Arens dar, und M ist jeweils das gleiche Metallatom. Beispiele für Anionen substituierter $\pi$-Arene sind die Anionen des Methyl-, Aethyl-, n-Propyl- und n-Butylcyclopentadiens, die Anionen des Dimethylcyclopentadiens, der Cyclopentadiencarbonsäuremethyl- und -äthylester sowie des Acetylcyclopentadiens, Propionylcyclopentadiens, Cyancyclopentadiens und Benzoylcyclopentadiens. Bevorzugte Anionen sind das Anion des unsubstiuierten Indens und insbesondere des unsubstituierten Cyclopentadiens.

Bevorzugt hat a den Wert 1, und $R^1$ steht für Benzol, Toluol, Xylol, Cumol, Methoxybenzol, Chlorbenzhol, p-Chlortoluol, Naphthalin, Methylnaphthalin, Chlornaphthalin, Methoxynaphthalin, Biphenyl, Inden, Pyren oder Diphenylensulfid, und $R^2$ steht für das Anion des Cyclopentadiens, Acetylcyclopentadiens oder Indens oder für Benzol, Toluol, Xylol, Trimethylbenzol, Naphthalin oder Methylnaphthalin.

M ist beispielsweise $Ti^{+}$, $Ti^{2+}$, $Ti^{3+}$, $Zr^{+}$, $Zr^{2+}$, $Zr^{3+}$, $Hf^{+}$, $Hf^{2+}$, $Hf^{3+}$, $Nb^{+}$, $Nb^{2+}$, $Nb^{3+}$, $Cr^{+}$, $Mo^{+}$, $Mo^{2+}$, $W^{+}$, $W^{2+}$, $Mn^{+}$, $Mn^{2+}$, $Re^{+}$, $Fe^{2+}$, $Co^{2+}$, $Co^{3+}$, $Ni^{2+}$ oder $Cu^{2+}$. Vorzugsweise ist M ein Chrom-, Kobalt-, Mangan-, Wolfram- oder Molybdänkation, insbesondere ein Eisenkation, und besonders bevorzugt $Fe^{2+}$.

Besonders bevorzugt sind solche Komplexe der Formel I, worin $a = 1$ ist, $R^1$ für $Eta^6$-Cumol oder $Eta^6$-2-Methylnaphthalin und $R^2$ für das Anion des $Eta^5$-Cyclopentadiens stehen, n vorzugsweise 1 oder 2, insbesondere 1, und q vorzugsweise 1 sind.

Beispiele für geeignete Metalle oder Nichtmetalle L sind Sb, Fe, Sn, Bi, Al, Ga, In, Ti, Zr, Sc, V, Cr, Mn und Cu; Lanthanide, wie Ce, Pr und Nd, oder Actinide, wie Th, Pa, U oder Np. Geeignete Nichtmetalle sind insbesondere B, P und As. L ist vorzugsweise P, As, B oder Sb, wobei P besonders bevorzugt wird.

Komplexe Anionen $[LQ_m]^{-q}$ sind beispielsweise $BF_4^-$, $PF_6^-$, $AsF_6^-$, $SbF_6^-$, $FeCl_4^-$, $SnCl_6^{2-}$, $SbCl_6^-$ und $BiCl_6^-$. Die besonders bevorzugten komplexen Anionen sind $SbF_6^-$, $BF_4^-$, $AsF_6^-$ und vor allem $PF_6^-$.

Beispiele für Verbindungen der Formel I sind ($Eta^6$-Toluol)($Eta^5$-indenyl)eisen(II)-hexafluorphosphat, ($Eta^6$-Pyren)($Eta^5$-cyclopentadienyl)eisen(II)hexafluorantimonat, ($Eta^6$-Toluol)-($Eta^5$-cyclopentadienyl)eisen(II)hexafluorphosphat, ($Eta^6$-Naphthalin)($Eta^5$-cyclopentadienyl)eisen(II)-hexafluorarsenat ($Eta^6$-2-Methylnaphthalin)($Eta^5$-cyclopentadienyl)eisen(II)hexafluorphosphat, ($Eta^6$-Cumol)($Eta^5$-cyclopentadienyl)eisen(II)-hexafluorphosphat und ($Eta^6$-Benzol)($Eta^5$-cyclopentadienyl)kobalt(III)bis(tetrafluorborat). Solche Metallocensalze und deren Herstellung sind z.B. in der europäischen Patentanmeldung Nr. 094 915 A2 beschrieben. Bevorzugt sind ($Eta^6$-2-Methylnaphthalin)($Eta^5$-cyclopentadienyl)eisen(II)-hexafluorphosphat und ($Eta^6$-Cumol)($Eta^5$-cyclopentadienyl)eisen(II)hexafluorphosphat.

Durch die Wahl geeigneter Füllstoffe können die elektrischen, thermischen und/oder optischen Eigenschaften der Epoxidharz-Systeme beeinflusst werden, wie z.B. die elektrisch oder thermisch leitenden bzw. isolierenden Eigenschaften, die ferroelektrischen oder ferromagnetischen Eigenschaften, die piezoelektrischen, elektrochromen oder nachleuchtenden Eigenschaften. Dadurch werden photohärtbare Harz-Zusammensetzungen erhalten, die nach dem Härten und Entwickeln Reliefstrukturen oder Abbildungen ergeben, die insbesondere auf den Gebieten der Hochfrequenztechnik, Elektronik, Mikroelektronik und Optoelektronik Anwendung finden, beispielsweise als aktive Komponenten in Widerständen, Kondensatoren, Transformatoren, Induktoren, Magneten, Speicher- und Anzeigematerialien, als passive Komponenten in elektrischen und thermischen Isolatoren, Wärmeableitungssystemen oder elektromagnetischen Abschirmungen, oder auch als sogenannte Interconnections, z.B. in Leiterbahnen oder bei der Chip-Kontaktierung sowie bei der Montage von Chips auf die Grundplatten ihrer Montagerahmen.

Als metallhaltige Füllstoffe oder Füllstoffe mit Halbleitereigenschaften kommen vor allem Metalle, Metallverbindungen und -legierungen in Betracht, in denen das Metall ein solches der Gruppen IIa, IIIa, IVa, Ib, Vb, VIb und/oder VIII des periodischen Systems ist. Je nach den gewünschten Eigenschaften oder dem Einsatzgebiet der erfindungsgemässen Epoxidharz-Zusammensetzungen können z.B. die folgenden Füllstoffe verwendet werden:

1. Elektrisch leitende Füllstoffe organischer oder anorganischer Art, wie z.B. Russ und Graphit oder Metalle der Gruppen Vb, VIb, VIII und Ib des periodischen Systems, Legierungen und Salze davon, wie Halogenide, Oxide und Sulfide.

Beispiele geeigneter Metalle und Metallverbindungen sind:
Vanadium, Niob, Tantal, Molybdän, Wolfram, Kupfer, Edelmetalle, wie Pt, Pd, Ag und Au, AgPd-Legierungen, Silberoxid, Silberjodid, Kupfer(II)sulfid, Kupfer(I)jodid, Kupfer(II)oxid, Gold(III)bromid, -jodid und -oxid, Molybdän(IV)-sulfid, Niob(V)chlorid und -oxid, Palladiumjodid, Palladiumoxid, Platin(IV)bromid und -chlorid, Vanadium(III)chlorid, Vanadium(IV)oxid, Wolfram(VI)chlorid und -oxid. Bevorzugt sind Silber, Kupfer, Silber/Palladiumlegierungen, Palladium, Platin, Gold, Wolfram und Molybdän. Besonders bevorzugt sind Au, Pt, AgPd und vor allem Ag- und Cu-Pulver.

2. Thermisch leitende Füllstoffe oder Dielektrika, wie Aluminiumoxid, Berylliumoxid, Lithium-Aluminiumoxid und Siliziumcarbid.

3. Füllstoffe, welche die ferroelektrischen, ferromagnetischen, piezoelektrischen, elektrochromen und/oder optischen Eigenschaften der Epoxidharz-Zusammensetzungen beeinflussen, wie:

- Ferroelektrika, beispielsweise Bariumtitanat, Bleititanat, Bleizirkonat, $NaNbO_3$, $KNbO_3$, $AgNbO_3$ und $WO_3$, die unter anderem für Halbleiter, Kondensatoren und in Bild- und Datenspeichern in der Optoelektronik Anwendung finden. Bariumtitanat, Bleititanat und Bleizirkonat können auch zum Erzielen piezoelektrischer Eigenschaften eingesetzt werden, z.B. in der Hochfrequenztechnik. Andererseits weist Wolframoxid auch elektrochrome Eigenschaften auf und wird daher z.B. in Digitalanzeigen und in der Elektrographie verwendet. Bevorzugt sind als Ferroelektrika bzw. elektrochrome Füllstoffe Bariumtitanat, Bleititanat, Bleizirkonat und WO.
- Ferromagnetika und Ferrite der allgemeinen Zusammensetzung oder $M^{II}O \bullet Fe_2O_3$, worin $M^{II}$ ein zweiwertiges Metall, wie Zn, Cd, Co, Ni, Mn, Fe, Cu, Ba, Sr oder Mg darstellt. Als bevorzugte Ferromagnetika bzw. Ferrite seien $Fe_3O_4$, $NiFe_2O_4$, $CoFe_2O_4$ und die unter dem Handelsnamen Ferroxcube® bekannten Mangan-Zink-Ferrite, wie Ferroxcube 4C4, 3D3, 3B9, 3B7 und 3C8, genannt. Ferromagnetika und Ferrite werden u.a. als Dauermagnete ($M^{II}$ = z.B. Ba oder Sr) für Transformatoren, Induktoren, Isolatoren, Tonaufzeichnungssysteme, Ferritantennen, magnetische Verstärker oder in Ferritkernen, z.B. für Kernspeicher in elektronischen Datenverarbeitungsanlagen, verwendet.
- Phosphoreszierende Füllstoffe und Phosphoren mit nachleuchtenden Eigenschaften, wie z.B. CdS, CdZnS, SrS, MgS, CaS und insbesondere ZnS. Solche Materialien werden vor allem in elektro-optischen Anzeigen verwendet.

Zur Erreichung des erwünschten, möglichst isotropen physikalischen Effekts müssen die Füllstoffe in feinteiliger Form eingesetzt werden, insbesondere als kugelförmige oder stäbchenförmige, z.B. dendritische oder lamellare, Teilchen. Die mittlere Teilchengrösse liegt bei kugelförmigen Teilchen zwischen 0,2 und 5 $\mu$m (Mikrometer). Stäbchenförmige Teilchen, besonders dendritische und lamellare Teilchen, weisen eine Länge von 0,3-20 $\mu$m und eine Schichtdicke von 0,1-1 $\mu$m auf.

Für keramische Anwendungen bestimmte erfindungsgemässe Zusammensetzungen enthalten zusätzlich ein Flussmittel (d), vorzugsweise in einer Menge von 5-50 und insbesondere 10-40 Gew.%, bezogen auf das Gesamtgewicht der Zusammensetzung. Geeignete Flussmittel sind z.B. Quarzpulver und vor allem Glaspulver, wie Blei-borsilikatpulver, Borsilikatpulver und Wismut-bleisilikatpulver. Bevorzugt sind Glaspulver mit einem Brechungsindex unter 1,8 und einer Teilchengrösse im Bereich von 2-50 $\mu$m.

Die Komponente (a) liegt in einer Menge von 5-40 Gew.% vor, während der Photoinitiator (b) in einer Menge von 0.1-15 Gew.-%, bevorzugt in einer Menge von 0,3-4 Gew.% eingesetzt wird. Der Füllstoff (c) wird in einer Menge von 30-90 Gew.-%, mit Vorteil in einer Menge von 30-85 Gew.% verwendet, wobei die Menge an Füllstoff (c) und Flussmittel (d) im allgemeinen 95 Gew.%, bezogen auf das Gesamtgewicht der Zusammensetzung, nicht übersteigen soll.

Besonders bevorzugt sind Gemische enthaltend:

i) einen Polyglycidyläther eines Phenol- oder Kresol-Formaldehyd-Novolaks, Silberpulver, Glaspulver und (Eta$^6$-2-Methylnaphthalin)(Eta$^5$-cyclopentadienyl)eisen(II)hexafluorphosphat oder (Eta$^6$-Cumol)(Eta$^5$-cyclopentadienyl)eisen(II)-hexafluorphosphat als Photoinitiator.

ii) einen Polyglycidyläther eines Phenol- oder Kresol-Formaldehyd-Novolaks, Kupferpulver, Glaspulver und (Eta$^6$-2-Methylnaphthalin)(Eta$^5$-cyclopentadienyl)eisen(II)hexafluorphosphat oder

iii) ein flüssiges Bisphenol-A-Epoxidharz, Silberpulver und (Eta$^6$-2-Methylnaphthalin)(Eta$^5$-cyclopentadienyl)eisen(II)hexafluorphosphat oder (Eta$^6$-Cumol)(Eta$^5$-cyclopentadienyl)eisen(II)-hexafluorphosphat als Photoinitiator.

Die erfindungsgemässen Zusammensetzungen können auch weitere bekannte und in der Technik der photohärtbaren Materialien übliche Zusatzstoffe (e) enthalten. Beispiele für solche Zusatzstoffe sind Pigmente, Farbstoffe, Verstärkungsmaterialien, wie Glasfasern, sonstige Fasermaterialien, Flammhemmer, reaktive Verdünner für die Epoxidharze, wie Phenyl- oder Kresylglycidyläther, Butandioldiglycidyläther und Hexahydrophthalsäurediglycidyläther, Antistatika, Verlaufmittel, Trennmittel, Haftvermittler, Antioxidantien, Lichtschutzmittel und Sensibilisatoren für die Komponente (b), wie Thioxanthone, Phthalimide, Cumarine und Anthracene.

Enthalten die erfindungsgemässen Zusammensetzungen Flussmittel (d) oder weitere übliche Zusatzstoffe (e), so ergänzen sich die Komponenten (a), (b), (c), (d) und/oder (e) auf 100 Gew.%.

Die erfindungsgemässen Zusammensetzungen können auf an sich bekannte Weise durch Vermischen der einzelnen Komponenten hergestellt werden. Sie werden üblicherweise in Form von Lösungen in organischen Lösungsmitteln auf geeignete Trägermaterialien, wie Kunststoffolien, z.B. Polyesterfolien, Metalle, Metallegierungen, Halbmetalle, Halbleiter, Glasplatten, Keramik, Laminate, wie kupferkaschierte Epoxylaminate, $SiO_2$ oder $Si_3N_4$, appliziert. Als organische Lösungsmittel eignen sich z.B. polare, besonders polare aprotische Lösungsmittel, die einzeln oder in Mischungen verwendet werden können. Beispiele solcher Lösungsmittel sind: Alkohole, wie Methanol, Aethanol und Diacetonalkohol; Amide aliphatischer Monocarbonsäuren, wie N,N-Dimethylformamid und N,N-Dimethylacetamid; Aether, wie Diäthyläther, Di-n-butyläther, Tetrahydrofuran, Dioxan, 2-Methoxyäthanol, 1,2-Dimethoxyäthan, Diäthylenglykoldimethyläther, Diäthylenglykoldiäthyläther, Diäthylenglykolmono-n-butyläther, Triäthylenglykoldimethyläther; halogenierte Kohlenwasserstoffe, wie Methylenchlorid, Chloroform, Tetrachlorkohlenstoff, 1,2-Dichloräthan, 1,1,2-Trichloräthan, 1,1,2,2-Tetrachloräthan; Carbonsäureester und Lactone, wie Propylencarbonat, Essigsäureäthylester, Propionsäuremethylester, Benzoesäureäthylester, 1-Acetoxy-2-äthoxyäthan, 1-Acetoxy-2-methoxyäthan, $\gamma$-Butyrolacton und $\gamma$-Valerolacton; Sulfoxide, wie Dimethylsulfoxid und Tetramethylsulfoxid; Sulfone, wie Dimethylsulfon, Diäthylsulfon, Trimethylensulfon,, Tetramethylensulfon; Ketone, wie Dimethylketon, Methyläthylketon, Methylisobutylketon und Cyclohexanon; substituierte Benzole, wie Chlorbenzol und Nitrobenzol. Bevorzugte Lösungsmittel sind Carbonsäureester und Ketone, wie 2-Acetoxy-2-äthoxyäthan und Cyclohexanon.

Die Lösungen werden mittels üblicher Verfahren auf das Trägermaterial aufgebracht, z.B. durch Tauchen, Streichen, Sprühen, Aufstempeln, Aufschleudern oder durch Walzenauftrag.

Die erfindungsgemässen Zusammensetzungen können auch trocken appliziert werden, z.B. mittels Pulverbeschichtung.

Die Trockenschichtdicken liegen im allgemeinen je nach Verwendungszweck im Bereich von etwa 0,5 bis 200 $\mu$m, bevorzugt 5 bis 100 $\mu$m. Nach dem Beschichten wird gegebenenfalls vorhandenes Lösungsmittel auf übliche Weise entfernt, z.B. durch Erwärmen und gegebenenfalls zusätzlich im Vakuum.

Es ist auch möglich, mit den erfindungsgemässen Zusammensetzungen erhaltene Folien vor der weiteren Behandlung auf andere Substrate zu übertragen. So können z.B. auf Kunststoffolien hergestellte Filme nach dem Trocknen mittels eines Rollenlaminators auf andere Substrate, wie Glas- oder Keramikplatten, Monel®-Substrate (Ni-Cu-Legierungen) und Tombak-Substrate (Cu-Zn-Legierungen), z.B. versilberte oder vergoldete Tombak- und Monelsubstrate, übertragen werden.

Die Härtung der erfindungsgemässen Zusammensetzungen bzw. der damit erhaltenen Beschichtungen kann einstufig durch Photohärtung, insbesondere bei erhöhten Temperaturen, z.B. zwischen 80 und 130 °C, vorgenommen werden; sie wird jedoch zweckmässig zweistufig, d.h. durch Photohärtung, gefolgt von einer thermischen Nachhärtung, durchgeführt. Die Photohärtung kann sowohl mit sichtbarem als auch UV-Licht bei einer Wellenlänge von 200-600 nm und einer Lichtintensität von 150-8000 Watt, vorzugsweise bei 1000-5000 Watt, vorgenommen werden. Als Lichtquellen eignen sich beispielsweise Xenonlampen, Argonlampen, Wolframlampen, Kohlelichtbögen, Metallhalogenid- und Metall-Lichtbogenlampen, wie Niederdruck-, Mitteldruck- und Hochdruckquecksilberlampen, Argonionen-Laser, frequenzverdoppelte Nd-YAG-Laser (yttrium-aluminium garnet) und UV-Laser. Bevorzugt ist die Bestrahlung mit sichtbarem Licht (VIS) oder VIS-Lasern.

Die Bestrahlungszeit hängt von verschiedenen Faktoren ab, z.B. der Schichtdicke der erfindungsgemässen Zusammensetzung, der Art der Lichtquelle und deren Abstand von der zu belichtenden Schicht. Im allgemeinen liegt die Bestrahlungszeit zwischen 1 Sekunde und 600 Sekunden.

Die thermische Nachbehandlung (Nachhärtung) wird zweckmässig bei Temperaturen zwischen 50 und 150 °C, bevorzugt 60 und 130 °C, durchgeführt.

Nach dem Belichten und gegebenenfalls der thermischen Härtung werden die nicht belichteten Bildstellen durch Behandlung mit einem Lösungsmittel oder Lösungsmittelgemisch entwickelt. Geeignete Lösungsmittel sind z.B. solche der oben erwähnten Art. Bevorzugte Lösungsmittel für das Entwickeln sind Cyclohexanon und Gemische aus Propylencarbonat, Diäthylenglykol-mono-n-butyläther und $\gamma$-Butyrolacton.

Beschichtungen, die mit elektrisch leitende oder dielektrische Füllstoffe und Flussmittel enthaltenden Zusammensetzungen erhalten werden, eignen sich besonders für keramische Anwendungen, wie z.B. Dickschicht-Schaltungen auf keramischen Unterlagen oder Kontaktierungen auf keramischen Trägern für integrierte Schaltungen (Chips).

Dabei werden die Beschichtungen nach dem Härten zweckmässig bei erhöhten Temperaturen, vorzugsweise 250-1000 °C und besonders 400-900 °C eingebrannt. Dadurch werden leitende oder dielektrische Reliefstrukturen oder Abbildungen erhalten. Das Einbrennen erfolgt zweckmässig unter Lufteinfluss, $O_2$-, $N_2$- und/oder $H_2$-Atmosphäre. Bei Verwendung von Silberpulver als Füllstoff oder silberhaltigen Füllstoffen wird das Einbrennen bevorzugt unter $O_2$-Atmosphäre vorgenommen. Wird als Füllstoff Kupferpulver oder eine Kupferverbindung eingesetzt, so führt man das Einbrennen mit Vorteil zuerst unter $O_2$ und anschliessend unter $N_2$ oder $H_2$ oder Gemischen beider Gase durch.

Wie schon erwähnt, eignen sich die erfindungsgemässen Zusammensetzungen zur Anwendung auf verschiedenen Gebieten der Technik, insbesondere der Elektronik, Mikroelektronik und Optoelektronik. Gegenstand vorliegender Erfindung ist somit auch die Verwendung der erfindungsgemässen Zusammensetzungen zum Erzeugen von Reliefstrukturen, Abbildungen oder Verklebungen mittels Photohärtung und gegebenenfalls thermischer Nachhärtung. Bevorzugte Anwendungen sind:

Bei Verwendung elektrisch leitender Füllstoffe:

- für Leiterbahnen auf Keramik, emaillierten Stahlplatten, polymeren Leiterplatten oder flexiblen Kunststoffolien;
- die Herstellung von Elektrodenmustern auf Aluminium und Glas für Flüssigkristallanzeigen und dergleichen;
- für Druckkontakte auf flexiblen Kunststoffolien für Tastaturen;
- für Kontaktverklebungen zwischen Chips und deren Trägern;
- das Aufkleben aktiver und passiver Komponenten der Mikroelektronik auf Leiterplatten (aus Keramik, emailliertem Stahl oder Kunststoffen);
- die Ausbesserung beschädigter Leiterbahnen und Kontakte in elektronischen Systemen, Komponenten und Modulen.

Bei Verwendung dielektrischer Füllstoffe:

- die Isolierung benachbarter oder sich verengender Leiterbahnen auf Keramik-, emaillierten Stahl- und Kunststoff-Substraten;
- für Schutzschichten als Abdeckungen von elektronischen und mikroelektronischen Schaltelementen, Kontakten und Leiterbahnen.

Bei Verwendung thermisch leitender Füllstoffe:

- für Wärmeabfuhrsysteme in der Hochleistungs- und Hochfrequenzelektronik

Bei Verwendung von ferroelektrischen Füllstoffen:

- die Erzeugung druck- und schallempfindlicher Sensoren auf der Basis von piezoelektrischen Effekten;
- der Aufbau optoelektronischer Anzeigeelemente.

Bei Verwendung von elektrochromen Füllstoffen:

- der Aufbau elektrochromer Anzeigeelemente.

Bei Verwendung von phosphoreszierenden Füllstoffen oder Phosphoren:

- der Aufbau fein strukturierter Kathodenstrahlröhren-Anzeigen;
- das Anbringen von nachleuchtenden Markierungen auf Masken für photographische oder lithographische Zwecke, auf verschiedenen Artikeln, Schildern und Oberflächen zu Informations-, Sicherheits- und Dekorationszwecken.

Besonders bevorzugt ist die Verwendung der erfindungsgemässen Zusammensetzungen (mit Flussmittel) zur Herstellung von Dickschicht-Schaltungen.

In den folgenden Beispielen bedeuten Teile Gewichtsteile, sofern nichts anderes angegeben ist.

Beispiel : Zu 6,75 Teilen einer 60 %igen Lösung eines Epoxy-Novolakharzes (Molekulargewicht ca. 1270, Epoxidäquivalentgewicht 238g/Äquivalent, Epoxidgehalt 4,2 Äquiv./kg) in 1-Acetoxy-2-äthoxyäthan werden 10 Teile Silberpulver (mittlere Teilchengrösse 2-3,5 µm der Fa. Ventron) und 5 Teile eines Glaspulvers (sog. "low expansion glass frit E 1980®" der Fa. Drakenfeld) gegeben, mit 1,25 Teilen 1-Acetoxy-2-äthoxyäthan verdünnt und 15 Stunden in einer mit Glaskugeln (Durchmesser 4 mm) versehenen Kugelmühle gemahlen. Anschliessend gibt man 0,18 Teile (Eta$^6$-2-Methylnaphthalin)(Eta$^5$-cyclopentadienyl)eisen(II)-hexafluorphosphat, gelöst in 0,5 Teilen N,N-Dimethylformamid und 0,5 Teilen 1-Acetoxy-2-äthoxyäthan, hinzu. Mit Hilfe eines 50 µm-Rakels wird auf einer Polyäthylenterephthalatfolie ein Film des so erhaltenen Gemisches aufgezogen und dieser 10 Minuten bei 80 °C getrocknet. Mittels eines Rollenlaminators wird dieser Film dann bei 130 °C auf eine $Al_2O_3$/Keramikplatte übertragen (Rubalith®-Substrat für Dickfilmschaltungen der Fa. Rosenthal Technik AG).

Der Film wird mittels einer Photomaske, die ein typisches Erscheinungsbild einer gedruckten Schaltung, einen 12-stufigen Stouffer-Keil sowie eine die Auflösung bestimmende Balkenmuster-Maske der Firma ITEK zur Beurteilung der Auflösung wiedergibt, während 5 Minuten mit einer 1000 W Halogenlampe bestrahlt, während 5 Minuten bei 110 °C thermisch gehärtet und in einem Entwickler-Bad aus 50 Teilen Propylencarbonat, 30 Teilen Diäthylenglykol-mono-n-butyläther und 20 Teilen γ-Butyrolacton entwickelt. Man erhält das Leiterbild der gedruckten Schaltung sowie sauber aufgelöste Linien des Balkenmusters mit einer Breite von 50 µm. Das Leiterbild wird während 80 Minuten bei 800 °C in einem Muffelofen eingebrannt. Danach zeigen die Leiterbahnen einen Flächenwiderstand von 20 mOhm (Dicke der Beschichtung 8 µm). Letzte vollständig abgebildete Stufe auf dem 12 stufigen Stoufferkeil nach dem Einbrennen: Stufe 8 (was bekanntlich ein Mass für die Lichtempfindlichkeit darstellt).

Verwendet man anstelle von 0,18 Teilen ($Eta^6$-2-Methylnaphthalin)($Eta^5$-cyclopentadienyl)eisen(II)-hexafluorphosphat entsprechende Menge ($Eta^6$-Cumol)($Eta^5$-cyclopentadienyl)eisen(II)-hexafluorphosphat, so erhält man Leiterbilder mit ähnlich guten Eigenschaften.

## Patentansprüche

**1.** Photohärtbare gefüllte Epoxid-Zusammensetzungen enthaltend

a) 5 - 40 Gew.-% eines von olefinisch ungesättigten C=C-Doppelbindungen freien Epoxidharzes oder Epoxidharzgemisches

b) 0,1 - 15 Gew.-% mindestens eines Photoinitiators der Formel I

$$[(R^1)(R^2M)_a]^{+an}\ an/q\ [LQ_m]^{-q} \quad (I),$$

worin a 1 oder 2 und n und q unabhängig voneinander je eine ganze Zahl von 1 bis 3 sind,

M das Kation eines einwertigen bis dreiwertigen Metalls aus den Gruppen IVb bis VIIb, VIII oder Ib des periodischen Systems darstellt,

m eine der Wertigkeit von L entsprechende ganze Zahl ist und

Q ein Halogenatom,

L ein zweiwertiges bis siebenwertiges Metall oder Nichtmetall,

$R^1$ ein π-Aren und $R^2$ ein π-Aren oder das Anion eines π-Arens bedeuten, und

c) 30 - 90 Gew.-% mindestens eines feinteiligen Füllstoffes, ausgewählt aus der Gruppe bestehend aus Russ, Graphit, metallhaltigen Füllstoffen, Füllstoffen mit Halbleitereigenschaften, der in Form von im wesentlichen kugelförmigen, dendritischen oder lamellaren Teilchen vorliegt, wobei die mittlere Teilchengrösse bei den im wesentlichen kugelförmigen Teilchen zwischen 0,2 und 5 µm liegt und die dendritischen und lamellaren Teilchen eine Länge von 0,3 bis 20 µm und eine Schichtdicke von 0,1 bis 1 µm aufweisen, und

wobei sich die genannten Komponenten mit gegebenenfalls zusätzlich vorhandenem Flussmittel (d) und/oder üblichen Zusatzstoffen (e) zu 100 Gew.-% ergänzen.

**2.** Zusammensetzung nach Anspruch 1, worin das Epoxidharz (a) ein gegebenenfalls vorverlängerter Diglycidyläther eines zweiwertigen Phenols oder eines zweiwertigen aliphatischen Alkohols mit 2-4 C-Atomen, ein Polyglycidyläther eines Novolaks oder tetraglycidyliertes 4,4'-Diaminodiphenylmethan ist.

**3.** Zusammensetzung nach Anspruch 1, dadurch gekennzeichnet, dass a in Formel I die Zahl 1 ist, $R^1$ für Benzol, Toluol, Xylol, Cumol, Methoxybenzol, Chlorbenzol, p-Chlortoluol, Naphthalin, Methylnaphthalin, Chlornaphthalin, Methoxynaphthalin, Biphenyl, Inden, Pyren oder Diphenylensulfid und $R^2$ für das Anion des Cyclopentadiens, Acetylcyclopentadiens oder Indens oder für Benzol, Toluol, Xylol, Trimethylbenzol, Naphthalin oder Methylnaphthalin stehen.

**4.** Zusammensetzung nach Anspruch 1, dadurch gekennzeichnet, dass a in Formel I die Zahl 1 ist, $R^1$ $Eta^6$-Cumol oder $Eta^6$-2-Methylnaphthalin und $R^2$ das Anion des $Eta^5$-Cyclopentadiens darstellen und n 1 oder 2 und q 1 sind.

**5.** Zusammensetzung nach Anspruch 1, dadurch gekennzeichnet, dass M ein Chrom-, Kobalt-, Mangan-, Wolfram-, Molybdän- oder Eisenkation ist und $[LQ_m]^{-q}$ $SbF_6^-$, $BF_4^-$, $AsF_6^-$ oder $PF_6^-$ bedeutet.

**6.** Zusammensetzung nach Anspruch 1, worin der metallhaltige Füllstoff oder der Füllstoff mit Halbleitereigenschaften ein Metall, eine Metallverbindung oder -legierung ist, in denen das Metall ein solches der Gruppen IIa, IIIa, IVa, Ib, Vb, VIb und/oder VIII des periodischen Systems ist.

**7.** Zusammensetzung nach Anspruch 1, worin der metallhaltige Füllstoff Silber, Kupfer, eine Silber/Palladiumlegierung, Palladium, Platin, Gold, Wolfram oder Molybdän ist.

**8.** Zusammensetzung nach Anspruch 1, worin der metallhaltige Füllstoff Au, Pt, AgPd und insbesondere Ag- oder Cu-Pulver ist.

**9.** Zusammensetzung nach Anspruch 1, worin der Füllstoff Aluminiumoxid, Berylliumoxid, Lithium-Aluminiumoxid, Siliziumcarbid, Bariumtitanat, Bleititanat, Bleizirkonat, $WO_3$, $Fe_3O_4$, $NiFe_2O_4$, $CoFe_2O_4$, ein Mangan-Zink-Ferrit oder Zns ist.

**10.** Zusammensetzung nach Anspruch 1, welche zusätzlich 5-50 Gew.% eines Flussmittels (d) enthält, wobei sich die Komponenten (a) bis (d) auf 100 Gew.% ergänzen.

**11.** Verwendung der Zusammensetzungen nach Anspruch 1 zum Erzeugen von Reliefstrukturen, Abbildungen oder Verklebungen mittels Photohärtung, gegebenenfalls gefolgt von einer thermischen Nachhärtung.

## Claims

**1.** A photocurable filled epoxy resin composition comprising

a) 5 - 40% by weight of an epoxy resin or epoxy resin mixture, which is free from olefinically unsaturated C=C double bonds,

b) 0.1 - 15% by weight of at least one photoinitiator of the formula I

$[(R^1)(R^2M)_a]^{+an}$ an/q $[LQ_m]^{-q}$ (I),

in which a is 1 or 2 and n and q are independently of one another each an integer from 1 to 3,

M is the cation of a monovalent to trivalent metal from Groups IVb to VIIb, VIII or Ib of the periodic system,

m is an integer corresponding to the valency of L and

Q is a halogen atom,

L is a divalent to heptavalent metal or non-metal,

$R^1$ is a $\pi$-arene and $R^2$ is a $\pi$-arene or the anion of a $\pi$-arene, and

c) 30 - 90% by weight of at least one finely particulate filler selected from the group consisting of carbon black, graphite, metal-containing fillers and fillers with semiconductor properties, which is in the form of essentially spherical, dendritic or lamellar particles, the average particle size of the essentially spherical particles being between 0,2 and 5 $\mu$m and the dendritic and lamellar particles having a length of 0,3 to 20 $\mu$m and a layer thickness of 0.1 to 1 $\mu$m, and

the sum of the stated components being 100% by weight with the optional addition of a fluxing agent (d) and/or conventional additives (e).

**2.** A composition according to claim 1, in which the epoxy resin (a) is an optionally pre-extended diglycidyl ether of a dihydric phenol or of a dihydric aliphatic alcohol having 2-4 carbon atoms, a polyglycidyl ether of a novolak or a tetra-glycidylated 4,4'-diaminodiphenylmethane.

**3.** A composition according to claim 1, wherein in formula I a is 1, $R^1$ is benzene, toluene, xylene, cumene, methoxybenzene, chlorobenzene, p-chlorotoluene, naphthalene, methylnaphthalene, chloronaphthalene, methoxynaphthalene, biphenyl, indene, pyrene or diphenylene sulfide and $R^2$ is the anion of cyclopentadiene, acetylcyclopentadiene or indene or is benzene, toluene, xylene, trimethylbenzene, naphthalene or methylnaphthalene.

**4.** A composition according to claim 1, wherein in formula I a is 1, $R^1$ is eta$^6$-cumene or eta$^6$-2-methylnaphthalene and $R^2$ is the anion of eta$^5$-cyclopentadiene and n is 1 or 2 and q is 1.

**5.** A composition according to claim 1, wherein M is a chromium, cobalt, manganese, tungsten, molybdenum or iron cation and $[LQ_m]^{-q}$ is $SbF_6^-$, $BF_4^-$, $AsF_6^-$ or $PF_6^-$.

**6.** A composition according to claim 1, in which the metal-containing filler or the filler with semiconductor properties is a metal, a metal compound or a metal alloy in which the metal is from Groups IIa, IIIa, IVa, Ib, Vb, VIb and/or VIII of the periodic system.

**7.** A composition according to claim 1, in which the metal-containing filler is silver, copper, a silver/palladium alloy, palladium, platinum, gold, tungsten or molybdenum.

**8.** A composition according to claim 1, in which

the metal-containing filler is Au, Pt, AgPd and in particular Ag- or Cu-powder.

**9.** A composition according to claim 1, in which the filler is aluminium oxide, beryllium oxide, lithium aluminium oxide, silicon carbide, barium titanate, lead titanate, lead zirconate, $WO_3$, $Fe_3O_4$, $NiFe_2O_4$, $CoFe_2O_4$, a manganese/zinc ferrite or ZnS.

**10.** A composition according to claim 1, which additionally contains 5-50% by weight of a fluxing agent (d), the sum of components (a) to (d) being 100% by weight.

**11.** The use of a composition according to claim 1 for producing relief structures, images or adhesive bonds by photocuring optionally followed by a thermal post-curing.

### Revendications

**1.** Compositions de résines époxydes photodurcissables, avec charges, qui comprennent :

a) de 5 à 40 % en poids d'une résine époxyde sans doubles liaisons oléfiniques ou de plusieurs de ces résines époxydes,

b) de 0,1 à 15 % en poids d'un ou de plusieurs photoinducteurs de formule I cidessous :

$$[(R^1)(R^2M)_a]^{+an}\ an/q\ [LQ_m]^{-q} \qquad (I),$$

dans laquelle a est le nombre 1 ou 2 et n et q sont chacun, indépendamment l'un de l'autre, un entier de 1 à 3,

M représente le cation d'un métal monovalent, divalent ou trivalent des groupes IVb à VIIb, VII ou Ib de la classification périodique,

m est un entier égal à la valence de L et

Q un atome d'halogène,

L désigne un métalloïde ou un métal divalent à heptavalent,

$R^1$ un $\pi$-arène et $R^2$ un $\pi$-arène ou l'anion d'un $\pi$-arène,

c) de 30 à 90 % en poids d'une ou plusieurs charges en fines particules prises parmi le noir de fumée, le graphite, des charges métallifères ou à propriétés semiconductrices, dont les particules ont essentiellement la forme de sphérules ou une forme dendritique ou lamellaire, la dimension moyenne des particules étant de 0,2 à 5 $\mu$m pour des sphérules et la longueur de particules dendritiques ou lamellaires étant de 0,3 à 20 $\mu$m avec une épaisseur de couche de 0,1 à 1 $\mu$m,

les composants ci-dessus pouvant être éventuellement complétés à 100 % par des flux (d) et/ou par des additifs courants (e).

**2.** Composition selon la revendication 1 dont la résine époxyde (a) est un éther diglycidylique éventuellement préallongé d'un phénol divalent ou d'un alcool aliphatique divalent ayant de 2 à 4 atomes de carbone, un éther polyglycidylique d'une novolaque ou du 4,4'-diaminodiphénylméthane tétraglycidylé.

**3.** Composition selon la revendication 1, caractérisée en ce que dans la formule I a est le nombre 1, $R^1$ représente le benzène, le toluène, un xylène, le cumène, le méthoxybenzène, le chlorobenzène, le p-chlorotoluène, le naphtalène, le méthylnaphtalène, le chloronaphtalène, le méthoxynaphtalène, le biphényle, l'indène, le pyrène ou le sulfure de diphénylène, et $R^2$ l'anion du cyclopentadiène, de l'acétylcyclopentadiène ou de l'indène ou bien le benzène, le toluène, un xylène, le triméthylbenzène, le naphtalène ou le méthylnaphtalène.

**4.** Composition selon la revendication 1, caractérisée en ce que dans la formule I a est le nombre 1, $R^1$ représente l'eta$^6$-cumène ou l'éta$^6$-2-méthylnaphtalène et $R^2$ l'anion de l'eta$^5$-cyclopentadiène, n est le nombre 1 ou 2 et q le nombre 1.

**5.** Composition selon la revendication 1, caractérisée en ce que M est un cation de chrome, cobalt, manganèse, tungstène, molybdène ou fer et $[LQ_m]^{-q}$ représente $SbF_6^-$, $BF_4^-$, $AsF_6^-$ ou $PF_6^-$.

**6.** Composition selon la revendication 1 dont la charge métallifère ou la charge à propriétés semi-conductrices est un métal ou bien un composé de métal ou un alliage de métaux des groupes IIa, IIIa, IVa, Ib, Vb, VIb et/ou VIII de la classification périodique.

**7.** Composition selon la revendication 1 dans laquelle la charge métallifère est de l'argent, du cuivre, un alliage d'argent et de palladium, du palladium, du platine, de l'or, du tungstène ou du molybdène.

**8.** Composition selon la revendication 1 dont la charge métallifère est de l'or, du platine ou un alliage d'argent et de palladium, et en particulier une poudre d'argent ou de cuivre.

**9.** Composition selon la revendication 1 dans laquelle la charge est de l'oxyde d'aluminium,

de béryllium ou de lithium ou de lithium et aluminium, du carbure de silicium, du titanate de baryum ou de plomb, du zirconate de plomb ou encore $WO_3$, $Fe_3O_4$, $NiFe_2O_4$, $CoFe_2O_4$, ou une ferrite de manganèse et zinc ou Zns.

**10.** Composition selon la revendication 1 qui contient en outre de 5 à 50 % en poids d'un flux (d), les composants (a) à (d) formant au total 100 %.

**11.** L'emploi des compositions selon les revendications précédentes pour la production de structures en relief, images et représentations ou collages, par un photodurcissement éventuellement suivi d'un durcissement sous l'action de la chaleur.